# EUROPÄISCHE PATENTANMELDUNG

(11) **EP 0 964 449 A2**
(43) Veröffentlichungstag der Anmeldung: **15.12.1999**
(21) Anmeldenummer: 99109982.1
(22) Anmeldetag: 20.05.1999
(51) Int. Cl.: H01L 23/522, H01L 23/525, H01L 23/528, H01L 27/02

(54) **Integrierte Halbleiterschaltung mit Füllstrukturen**

(30) Priorität: 08.06.1998 DE 19825607
(71) Anmelder: SIEMENS AKTIENGESELLSCHAFT, 80333 München (DE)
(72) Erfinder: Savignac, Dominique, Dr., 85737 Ismaning (DE); Feurle, Robert, 85579 Neubiberg (DE); Schneider, Helmut, 80993 München (DE)

(57) **Zusammenfassung**

Zur Anpassung der Eingangs-/Ausgangsparameter der Anschlußflächen (1) einer integrierten Halbleiterschaltung an eine externe Leitung wird ein Teil der in Füllstrukturen vorhandenen kapazitiven Elemente (6, 7, 8) verwendet. Für die Zuschaltung eignen sich Metalloptionen, Sicherungen (9, 10, 11) oder Schalter. Diese Lösung ist flächenneutral.

## Beschreibung

Die Erfindung betrifft eine integrierte Halbleiterschaltung nach dem Oberbegriff des Patentanspruchs 1.

Integrierte Halbleiterschaltungen weisen bekanntlich Anschlußflächen, sogenannte Pads, auf, die an Anschlußstifte eines Gehäuses kontaktiert sind und über die die von der Halbleiterschaltung zu verarbeitenden Eingangs- oder Ausgangssignale zu- bzw. abgeführt werden oder an die ein Versorgungspotential angelegt wird. Insbesondere bei den Pads für Signaleingabe und -ausgabe besteht das Erfordernis, eine Anpassung an die angeschlossene Leitung vorzunehmen.

Halbleiterschaltkreise mit dem gleichen Schaltungsentwurf sollen beispielsweise an verschiedene Bussysteme angeschlossen werden. Durch geeignete Schaltungsmaßnahmen sind dann die Ein-/Ausgabeparameter der Anschlüsse durch eine geeignete Kapazitäts- und Widerstandsbeschaltung auf den gewünschten Wert anzupassen. Wenn hierzu entsprechende Bauelemente außerhalb der integrierten Halbleiterschaltung verwendet werden, führt dies zu einem höheren Aufwand beim Platinenentwurf und dementsprechenden Nachteilen, z.B. erhöhtes Ausfallrisiko. Wenn solche Bauelemente andererseits mit herkömmlichen Mitteln auf dem Halbleiterchip integriert realisiert werden, wird der Flächenbedarf der Schaltung insbesondere durch die Realisierung von Kapazitäten erhöht. Zur Herstellung des integrierten Kondensators sind eine Vielzahl von bis in tiefere Schichten des integrierten Schaltkreises hineinreichende Prozeßschritte erforderlich. Die integrierte Realisierung bedingt daher außerdem zusätzlichen Entwicklungsaufwand und eine Vielzahl von jeder Anpassungsvariante eigens zugeordneten Belichtungsmasken.

In der europäischen Patentanmeldung EP-A2-0 409 256 ist eine integrierte Halbleiterschaltung beschrieben, bei der Füllstrukturen verwendet werden, um die interne Versorgungsspannung zu stabilisieren oder die Verzögerungszeit für ein internes Signal einzustellen. Hierzu werden für andere Zwecke nicht benötigte Metalleitungen der Füllstruktur mit einer Versorgungspotentialleitung bzw. dem Signalausgang eines Schaltungsblocks verbunden. Die Länge der Signalleitung wird mittels Laserstrahl getrimmt, um die gewünschte Kapazität bereitzustellen.

Die Aufgabe der Erfindung besteht darin, eine integrierte Halbleiterschaltung anzugeben, bei der die Anpassung an Ein-/Ausgangsparameter ihrer Anschlüsse mit geringeren Aufwand durchführbar ist.

Diese Aufgabe wird durch eine integrierte Halbleiterschaltung nach den Merkmalen des Patentanspruchs 1 gelöst.

In der Erfindung werden im integrierten Schaltkreis ohnehin vorhandene Füllstrukturen (dummy structures) verwendet. Solche Füllstrukturen sind beispielsweise in den US-Patentschriften 5 032 890 und 5 278 105 beschrieben. Sie bestehen aus regelmäßigen Strukturen, die an freien, ungenutzten Flächen des Halbleiterchips angeordnet sind, um ein gleichmäßiges Prozeßverhalten der Gesamtschaltung während der Herstellung, z.B. beim Ätzen, beim Aufwachsen von Strukturen oder beim chemisch-mechanischen Polieren, sicherzustellen und um eine gleichmäßig ebene, planare Oberfläche zu erhalten. Diese Füllstrukturen sind bisher elektrisch ohne Funktion. Bei der Erfindung wird ein Teil dieser Füllstrukturen entsprechend dem gewünschten Eingangs-/Ausgangssignalverhalten an das Anschlußpad angeschlossen und deren kapazitive Wirkung ausgenutzt. Ein zusätzlicher Flächenbedarf entsteht nicht. Der zusätzliche Prozeßaufwand liegt im Vorsehen einer entsprechenden Verdrahtung, die in den obersten Schichten der Halbleiterschaltung verläuft. Es sind daher nur die obersten Belichtungsmasken anzupassen; die darunter liegenden Strukturen bleiben unverändert.

Alternativ können statt einer Metallverdrahtung auch Sicherungen verwendet werden, über die gegebenenfalls zu größeren Bereichen zusammengefaßte Teile der Füllstrukturen mit den Anschlußflächen verbunden werden. Im Anschluß an die Maskenprozeßschritte während der Herstellung werden Sicherungen durchgeschmolzen, um die kapazitive Belastung des Anschlußpads auf den gewünschten Wert zu trimmen. Eine Vielzahl von unterschiedlichen Einstellungen der Ein-/Ausgabeparameter wird dadurch flexibel und schnell erhalten.

Alternativ oder in Kombination mit den obigen Ausführungsformen werden Teile der Füllstrukturen über Schalter mit dem Ausgangsanschluß gekoppelt, deren Schaltzustand im Betrieb des Halbleiterspeichers eingestellt wird.

Weitere vorteilhafte Ausgestaltungen der Erfindung, insbesondere die geeignete Ausführung der Füllstrukturen, sind in den Figuren dargestellt. Nachfolgend wird die Erfindung anhand der in der Zeichnung dargestellten Figuren erläutert. Es zeigen
- Figur 1: ein Prinzipschaltbild der Erfindung,
- Figur 2: einen Querschnitt und eine Aufsicht durch eine Füllstruktur,
- Figur 3: verschiedene, zu größeren Bereichen zusammengefaßte und über Sicherungen miteinander verbundene Kapazitätselemente der Füllstruktur und
- Figur 4: ein Ausführungsbeispiel zur Verbindung der Füllstruktur mit dem Anschlußpad während des Betriebs.

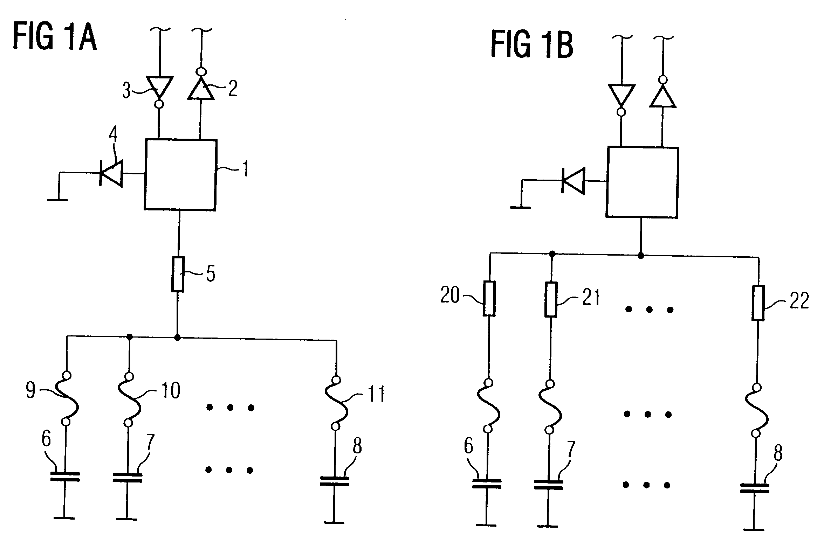

In Figur 1 (a) ist ein Anschlußpad 1 dargestellt. Dies ist ein flächenhaft ausgebildeter Bereich der Metallisierung, an dem der integrierten Schaltung ein Eingangssignal zugeführt oder ein Ausgangssignal abgegriffen wird. Außerdem kann ein Versorgungspotential zugeführt werden. Das sogenannte Pad 1 wird mit den durch das Gehäuse der integrierten Schaltung führenden Anschlußstiften, meist über einen Bonddraht, verbunden. Im gezeigten Ausführungsbeispiel dient das Pad 1 zur Ein- oder Ausgabe eines von der integrierten Schaltung zu verarbeitenden Signals. Ein solches wird über einen Eingangsverstärker 2 empfangen oder über einen Ausgangsverstärker 3 abgegeben. Darüber hinaus ist das Pad 1 durch eine Schutzstruktur 4 vor elektrostatischer Entladung geschützt.

Eine Anordnung 5, ..., 11 dient zur genauen Einstellung des Eingangs-/Ausgangssignalverhaltens der am Pad 1 ein- bzw. ausgegebenen Signale. Die Anordnung 5, ..., 11 ist ein RC-Glied mit einstellbarer Zeitkonstante. Ein Widerstand 5 wird über eine Vielzahl von parallel schaltbaren Kondensatoren, von denen die Kondensatoren 6, 7, 8 dargestellt sind, nach Masse verbunden. Die Kondensatoren sind über jeweilige Sicherungen 9, 10 bzw. 11 an den Widerstand 5 angeschlossen. Die Sicherungen sind nach der Herstellung für alle Kondensatoren leitend. Dann ist die kapazitive Belastung des Pads 1 maximal. Nach den Maskenschritten der Herstellung wird eine Anzahl von Sicherungen durchtrennt, so daß Kondensatoren abgetrennt werden. Die kapazitive Belastung des Pads 1 wird dadurch auf den gewünschten Wert eingestellt. Zum Trennen der Sicherung eignet sich ein Laserstrahl, der die jeweilige Sicherung schmilzt und zerstört. Alternativ können entsprechende Maßnahmen vorgesehen werden, um eine Sicherung mittels Stromimpulsen zu durchtrennen. Der Abgleich wird von einem Testautomaten aus gesteuert.

In Figur 1 (b) ist eine entsprechende Schaltung gezeigt, mit dem Unterschied, daß Widerstände 20, 21, 22 in die die Kondensatoren enthaltenden Strompfade geschaltet sind, so daß RC-Komponenten 20, 6; 21, 7; 22, 8 parallel geschaltet sind. Während in der Teilfigur (a) der Widerstand in bezug auf die Kapazitätsbeschaltung konstant ist, ist im Teilbild (b) die Zeitkonstante RC konstant. Durch Trennen entsprechender Sicherungen wird dort nur die kapazitive Belastung des Pads angepaßt.

Bei der in Figur 1 gezeigten Ausführung wird für verschiedene Ein-/Ausgangsparameter des Pads der gleiche Halbleiterschaltkreis verwendet. Die Masken werden nicht beeinflußt. Mit der elektrischen Anpassung der Anschlüsse kann daher flexibel und kurzfristig auf sich ändernde Kundenanforderungen reagiert werden.

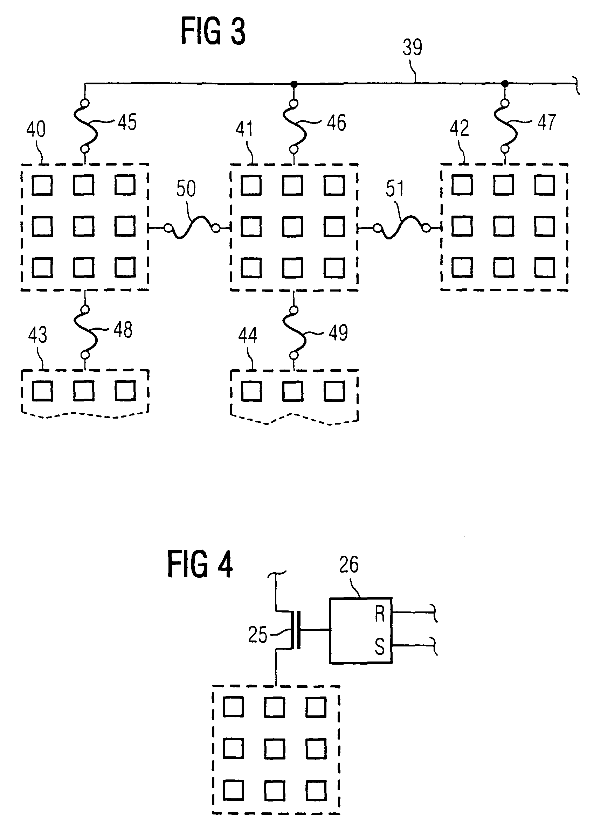

Alternativ zum Vorsehen von Sicherungen ist (nicht dargestellt) die Einstellung der Ein-/Ausgabeparameter eines Pads durch Maskenoption möglich. Dies bedeutet, daß nur ein Teil der ohnehin vorgesehenen kapazitiven Elemente während der Herstellung mittels Leiterbahnen, vorzugsweise Metalleiterbahnen, an das Pad angeschlossen wird. Es entfällt der Aufwand zum Trennen von Sicherungen im Testautomaten; demgegenüber ist die Maske der Metallverdrahtungsebene, die die Leiterbahnen enthält, anzupassen. Außerdem alternativ wird die Verbindung der kapazitiven Elemente mit dem Ausgangspad über einen Schalter bewirkt, im dargestellten Ausführungsbeispiel der Figur 4 durch einen Schalttransistor 25. Dessen Schaltzustand wird durch ein RS-Flip-Flop 25 eingestellt. Für diejenigen kapazitiven Elemente, die an das Pad anzuschließen sind, wird der Schalter 25 leitend gesteuert. Für die nicht anzuschließenden kapazitiven Elemente ist der Schalter 25 gesperrt. Das Flip-Flop 26 wird im Betrieb der Schaltung eingestellt. Diese Realisierung bietet den Vorteil, daß während des Betriebs der Schaltung die Anpassung der Ein-/Ausgabeparameter des Pads flexibel einstellbar ist.

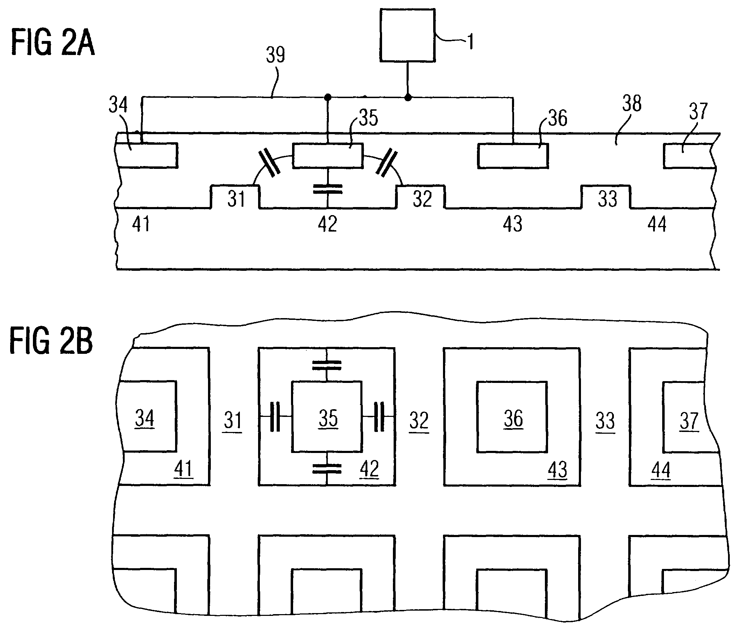

Füllstrukturen sind an sich bekannt. Diese sind außerhalb von aktiven Gebieten, die Dotierungsgebiete zur Bildung von Bauelementen (z.B. Dioden, Transistoren, Widerstände, Kondensatoren) enthalten, angeordnet, um ein gleichmäßiges Prozeßver-halten zu bewirken und die Oberfläche des Chips zu planarisieren. Figur 2 (a) zeigt einen Querschnitt durch eine Füllstruktur, Figur 2 (b) eine Aufsicht. Die Füllstruktur umfaßt zuunterst des Halbleitersubstrat 30. Durch selektives Ätzen erhält das Halbleitersubstrat 30 eine Oberflächenstruktur aus zurückgesetzten, erniedrigten Abschnitten 41, 42, 43, 44 und demgegenüber erhöhten, vorspringenden Abschnitten 31, 32, 33. Oberhalb der zurückgesetzten Abschnitte 41, ..., 44 ist je ein Flächenabschnitt 34, 35, 36, 37 angeordnet, der aus Polysilizium besteht. Das Flächenverhältnis zwischen Polysiliziumfläche und Gesamtfläche ist zweckmäßigerweise an das Flächenverhältnis zwischen aktiven Flächen, d.h. Dotierungsgebieten, zu Gesamtfläche im von Schaltungsteilen belegten Gebiet der Halbleiterschaltung angelehnt. Zwischen einer Polysiliziumfläche und den benachbarten zurückgesetzten und erhabenen Abschnitten des Substrats wird ein kapazitives Element gebildet. In Figur 1 (a) sind die wirksamen Teilkapazitäten am Beispiel der Polysiliziumfläche 35 eingezeichnet. Die Polysiliziumflächen können vollständig innerhalb der zurückgesetzten Abschnitte des Substrats liegen oder aber die hervorstehenden Abschnitte überdecken. Entsprechend ändert sich die gebildete Kapazität. Zwischen den Gebieten und dem Substrat befindet sich ein Oxid. Die Polysiliziumabschnitte sind bei Aufsicht rechteckig geformt. Sie sind bezüglich der zurückgesetzten Abschnitte 42 zentriert. Bezüglich vertikaler und horizontaler Richtung sind die Polysiliziumfläche und die Substratstruktur im gezeigten Ausführungssbeispiel symmetrisch ausgebildet. Das kapazitive Element ist in einem regelmäßigen Raster wiederholt angeordnet. In der gezeigten Ausführung ist der Rasterabstand und somit der Mittelpunkt der jeweiligen kapazitiven Elemente in vertikale und horizontale Richtung identisch.

Es liegt ein modularer Aufbau der kapazitiven Elemente der Füllstruktur vor. Entsprechend der gewünschten Kapazitätsbelegung des Anschlußpads 1 sind Teile der Kapazitätselemente 34, ..., 37 an das Anschlußpad 1 über eine symbolisch dargestellte Verbindungsleitung 39 angeschlossen. Diese verläuft als Metalleiterbahn innerhalb einer Verdrahtungsebene oberhalb der Polysiliziumabschnitte. Wie oben ausgeführt sind zusätzlich trennbare Sicherungen oder Schaltelemente vorgesehen, um den gewünschten Kapazitätswert nach der Herstellung oder gegebenenfalls während des Betriebs der Halbleiterschaltung einzustellen.

Die Leitung 39 weist einen Abschnitt auf, in dem die Widerstandswerte der Widerstände 5 oder 20, 21, 22 realisiert sind. Der Widerstandsabschnitt bildet den gewünschten Widerstandswert auf an sich bekannte Weise. Beispielsweise wird eine Metallegierung mit einem geeigneten Widerstandswert verwendet und/oder das Metall weist einen geeigneten Verlauf und geeigneten Querschnitt auf, um den gewünschten Widerstandswert einzustellen. Die räumliche Zuordnung der Widerstandsabschnitte in Relation zum Pad 1 und zu den Sicherungen oder Schaltelementen ergibt sich gemäß Figur 1.

Alternativ zu der in Figur 2 gezeigten in horizontale und vertikale Richtung symmetrisch ausgebildeten Füllstruktur kann auch eine streifenförmige Füllstruktur verwendet werden, die ebenfalls modular aufgebaut ist, aber nur bezüglich einer Richtung Symmetrieeigenschaften aufweist. Entsprechend der gewünschten Kapazitätsbelegung des Anschlußpads sind eine geeignete Anzahl von Polysiliziumstreifen sowie Streifen geeigneter Länge miteinander zum Anschlußpad zu verbinden.

In Figur 3 sind vereinfacht die Konturen der kapazitiven Element dargestellt. Eine Anzahl aus drei mal drei kapazitiven Elementen bilden einen von einer gestrichelten Linie umrandeten Bereich 40. Die Polysiliziumabschnitte innerhalb des Bereichs 40 sind untereinander über Metalleiterbahnen verbunden. Die einzelnen Bereiche 40, ..., 44 sind untereinander über entsprechende Sicherungen 45, ..., 51 miteinander verbunden. Die Sicherungen 45, 46, 47 führen zusammen auf eine Leitung, die mit dem Anschlußpad verbunden ist. Durch Auftrennen verschiedener Sicherungen können Bereiche zueinander in Reihe oder parallel geschaltet werden. Die mit dem Anschlußpad verbundene Kapazität kann dadurch relativ genau eingestellt werden. Die kapazitiven Elemente sind insgesamt im vorgegebenen Raster angeordnet. Zwei Bereiche, z.B. 40, 41 oder 40, 43, sind derart beabstandet, daß an einer Rasterstelle zwischen den Bereichen ein kapazitives Element fehlt, indem dort keine Polysiliziumfläche vorhanden ist. Die Bereiche 40, 41, ... wirken ihrerseits als einzelne Kondensatoren.

## Patentansprüche

1. Integrierte Halbleiterschaltung mit
- mindestens einer Anschlußfläche (1) für Ein- oder Ausgabe eines zu verarbeitenden Signals oder zur Zuführung eines Versorgungspotentials, und
- einer Füllstruktur (30, ..., 44), die eine Vielzahl von wiederholt angeordneten kapazitiven Elementen (34, ..., 37; 6, ..., 8) umfaßt,
- von denen jedes einen zurückgesetzten Abschnitt (41, ..., 44) und demgegenüber erhöhten Abschnitt (31, ..., 33) eines Halbleitersubstrats und einen dagegen isolierten Abschnitt aus Polysilizium (34, ..., 37) umfaßt,
- wobei zumindest ein Teil (34, ..., 36) der kapazitiven Elemente (34, ..., 37; 6, ..., 8) an die Anschlußfläche (1) gekoppelt ist.

2. Integrierte Halbleiterschaltung nach Anspruch 1,
**dadurch gekennzeichnet**, daß
für die Verbindung der kapazitiven Elemente (34, ..., 36; 6, ..., 8) mit der Anschlußfläche (1) je eine durchtrennbare Sicherung (9, ..., 11; 45, ..., 51) vorgesehen ist, daß die Sicherung, die den Teil der Vielzahl der Elemente mit der Anschlußfläche verbinden, nicht durchtrennt sind und daß die übrigen Sicherungen durchtrennt sind.

3. Integrierte Halbleiterschaltung nach Anspruch 1,
**dadurch gekennzeichnet**, daß
für die Verbindung der kapazitiven Elemente mit der Anschlußfläche (1) je ein Schaltelement (25) vorgesehen ist, daß die Schaltelemente, die den Teil der Vielzahl der Elemente mit der Anschlußfläche verbinden, während des Betriebs der Halbleiterschaltung leitend schaltbar ist, und daß die übrigen Schaltelemente während des Betriebs der Halbleiterschaltung gesperrt sind.

4. Integrierte Halbleiterschaltung nach einem der Ansprüche 1 bis 3,
**dadurch gekennzeichnet**, daß
die Füllstruktur (30, ..., 44) in von Transistoren nicht belegter Fläche der Halbleiterschaltung angeordnet ist, daß zwischen dem Substrat und den Abschnitten aus Polysilizum eine Oxidschicht (38) angeordnet ist, daß die Abschnitte aus Polysilizium (34, ..., 37) oberhalb zumindest der zurückgesetzten Abschnitte (41, ..., 44) des Halbleitersubstrats angeordnet sind, und daß ein Teil der Abschnitte aus Polysilizium (34, ..., 36) mit der Anschlußfläche (1) verbunden ist.

5. Integrierte Halbleiterschaltung nach Anspruch 4,
**dadurch gekennzeichnet**, daß
die Abschnitte aus Polysilizium (34, ..., 37) rechteckförmig ausgebildet sind und an vorgegebenen Stellen eines regelmäßigen Rasters angeordnet sind.

6. Integrierte Halbleiterschaltung nach Anspruch 5,
**dadurch gekennzeichnet**, daß
mehrere benachbarte Abschnitte aus Polysilizium miteinander gemeinsam zu einem Bereich (40, ..., 44) verbunden sind, daß diese gemeinsame Verbindung des Bereichs über eine durchtrennbare Sicherung (45, ..., 51) mit einer gemeinsamen Verbindung eines weiteren entsprechenden Bereichs verbunden ist, und daß die Sicherung, sofern der Bereich nicht mit der Anschlußfläche verbunden ist, durchtrennt ist.

7. Integrierte Halbleiterschaltung nach Anspruch 6,
**dadurch gekennzeichnet**, daß
jeder der Bereiche (40, ..., 44) eine Anzahl von miteinander verbundenen Abschnitten aus Polysilizium umfaßt und verschiedene Bereiche derart beabstandet sind, daß zwischen unmittelbar benachbarten Abschnitten aus Polysilizium dieser Bereiche eine Rasterstelle liegt, an der kein Abschnitt aus Polysilizium angeordnet ist.

8. Integrierte Halbleiterschaltung nach einem der Ansprüche 1 bis 7,
**dadurch gekennzeichnet**, daß
eine Leiterbahn (39), über die der Teil der Vielzahl der Elemente mit der Anschlußfläche (1) verbunden ist, einen Abschnitt aufweist, durch den ein vorbestimmter Widerstandswert (5, 20, ..., 22) eingestellt ist, und daß die Sicherung (9, ..., 11; 45, ..., 51) bzw. das Schaltelement zwischen diesem Abschnitt und dem Anschluß an Polysilizium angeordnet ist.

9. Integrierte Halbleiterschaltung nach Anspruch 8,
**dadurch gekennzeichnet**, daß
mehrere Abschnitte von Leiterbahnen, durch die jeweils der gleiche vorbestimmte Widerstandswert (20, 21, 22) eingestellt ist, elektrisch parallel geschaltet sind.
